(19) Europäisches Patentamt
European Patent Office
Office européen des brevets

(11) Veröffentlichungsnummer: **0 070 450**
**A1**

(12) **EUROPÄISCHE PATENTANMELDUNG**

(21) Anmeldenummer: **82106042.3**

(22) Anmeldetag: **07.07.82**

(51) Int. Cl.[3]: **C 08 F 8/42**, H 01 B 1/12, H 01 L 29/28, H 01 L 31/02

(30) Priorität: **16.07.81 DE 3128145**

(43) Veröffentlichungstag der Anmeldung: **26.01.83**
**Patentblatt 83/4**

(84) Benannte Vertragsstaaten: **BE DE FR GB NL**

(71) Anmelder: **BASF Aktiengesellschaft,**
***Carl-Bosch-Strasse 38, D-6700 Ludwigshafen (DE)***

(72) Erfinder: **Naarmann, Herbert, Dr., Haardtblick 15, D-6719 Wattenheim (DE)**
Erfinder: **Simak, Petr, Dr., Philipp-Scheidemann-Strasse 17, D-6700 Ludwigshafen (DE)**

(54) **Verfahren zur Herstellung von elektrisch leitfähigen Polymeren und deren Verwendung in der Elektrotechnik und zur antistatischen Ausrüstung von Kunststoffen.**

(57) Die Erfindung betrifft ein Verfahren zur Herstellung von stabilen elektrisch leitfähigen Polymeren mit elektrischen Leitfähigkeiten größer als $10^{-2}$ S/cm, wobei Polyacetylene, zweckmäßig mit 0,1 bis 30, bevorzugt 1 bis 5 Gew.-% einer stickstoffhaltigen organischen Verbindung modifiziert und dann mit 0,1 bis 70, bevorzugt 5 bis 35 Gew.-% eines Alkalimetalls, dessen Amids oder einer Lewis-Säure umgesetzt werden. Die erhaltenen Polymeren können in der Elektrotechnik zur Herstellung von Sonnenzellen, zur Umwandlung und Fixierung von Strahlung, zur Herstellung elektrischer und magnetischer Schalter und elektrischer Speicher und zur antistatischen Ausrüstung von Kunststoffen verwendet werden.

EP 0 070 450 A1

# Verfahren zur Herstellung von elektrisch leitfähigen Polymeren und deren Verwendung in der Elektrotechnik und zur antistatischen Ausrüstung von Kunststoffen

Die Erfindung betrifft ein Verfahren zur Herstellung von stabilen elektrisch leitfähigen Polymeren mit elektrischen Leitfähigkeiten größer als $10^{-2}$ S/cm aus Polyacetylenen.

Bei derartigen Verfahren sind Modifizierungen und Zusätze erforderlich, um eine erhöhte elektrische Leitfähigkeit bei Polyacetylenen zu bewirken.

Es ist bereits in der DE-OS 30 29 206, der DE-OS 30 27 529 und der DE-OS 30 26 328 vorgeschlagen worden, Polyacetylene durch Zugabe eines Komplexierungsmittels wie Schwermetallphosphorkomplexe, oder durch Zugabe von schwarzem Phosphor und Alkalimetall bzw. deren Amiden oder durch Zugabe von schwarzem Phosphor und einer starken Lewis-Säure in elektrisch leitfähige Polymere umzuwandeln. In der Literaturstelle DE-OS 31 04 408 ist es auch bereits beschrieben, organischen Polymeren aus der Reihe der Polyacetylene unter Ausschluß von Wasserfeuchtigkeit und von Sauerstoff mit Nitrosoderivaten und anschließend mit einer starken Lewis-Säure mit $pk_s$-Werten von -10 bis +4 oder mit einer starken Base zu versetzen, um elektrisch leitfähige Polymere zu erhalten. Zur Herstellung von stabilen elektrisch leitfähigen Polymeren ist auch schon vorgeschlagen worden, mit Lewis-Säuren p-gedopte elektrisch leitfähige Polyacetylene unter Ausschluß von Sauerstoff und Feuchtigkeit auf Temperaturen zwischen 500 und 1100°C zu erhitzen (vgl. DE-OS 31 05 948). In der DE-OS 31 18 630 ist es auch bereits beschrieben, Polyacetylene vor der Umsetzung mit Alkalimetall oder Lewis-Säure mit Tosylmethylisocyanid zu modifizieren.

Rss/P

Der Erfindung lag die Aufgabe zugrunde, nach einfacher chemischer Verfahrensweise elektrisch leitfähige Polymere auf Basis von modifiziertem Polyacetylen zu schaffen, die sich durch eine besonders hohe Stabilität gegenüber Wärme- und Lufteinwirkung auszeichnen.

Diese Aufgabe wurde dadurch gelöst, daß man Polyacetylen, bevorzugt mit 0,1 bis 30 Gew.-%, bezogen auf das Polyacetylen, mit einer stickstoffhaltigen organischen Verbindung modifiziert und anschließend mit 0,1 bis 70 Gew.-%, bezogen auf das Polyacetylen, eines Alkalimetalls, dessen Amids oder einer oxidierenden Lewis-Säure umsetzt. Nach bevorzugter Verfahrensweise wird in Gegenwart von Schwefelsäure mit organischen Nitrilen oder mit einer Mischung aus Paraformaldehyd und einem organischen Amin modifiziert. Nach besonders geeignetem Verfahren wird das Polyacetylen zu Polymeren mit Struktureinheiten der Formel (I):

$$[-(CH)_x-(\underset{R^1\;\;R^2}{CH})_y-]_n \qquad I,$$

wobei x, y und n Zahlen sind, x größer als y ist und x = 4 bis 990, y = 2 bis 10 und n = 6 bis 1000, $R^1$ = eine mono-, di-, oligo- oder polyfunktionelle Carbonamidgruppe oder ein Aminrest und $R^2$ Wasserstoff oder $SO_3H$ ist, modifiziert und anschließend mit Alkalimetall, dessen Amid oder oxidierender Lewis-Säure umgesetzt. Die Lewis-Säure ist bevorzugt ein Halogenderivat von Elementen der III., IV., V., VI., VII. oder VIII. Gruppe des Periodensystems der Elemente. Das modifizierte Polyacetylen kann bevorzugt auch mit einem Alkalimetall und/oder dessen Amid versetzt werden, wobei die Sulfogruppe als Salz vorliegt.

Unter elektrisch leitfähigen Polymeren mit elektrischen Leitfähigkeiten größer als $10^{-2}$ S/cm werden Substanzen verstanden, die nach der Meßmethode von F. Beck, "Berichte der Bunsengesellschaft, Physikalische Chemie" 68, (1964), Seiten 558 bis 567 eine elektrische Leitfähigkeit von mehr als $10^{-2}$ S/cm aufweisen.

Die Polyacetylene d.h. die Polymerisate des Acetylens, welche erfindungsgemäß zur Anwendung kommen, werden z.B. nach den Angaben der Literaturstellen US-PS 3 093 613 hergestellt. Die Herstellung der Ausgangspolymerisate ist nicht Gegenstand der Erfindung, es wird jedoch zweckmäßig anstelle von Nickelbromid-Trihydrat mit Nitraten, Chloriden, Acetylacetonaten und mit Kobalt als Metallion gearbeitet. Als Reduktionsmittel wird vorzugsweise statt des Natriumborhydrids Lithiumborhydrid oder Lithiumalanat verwendet, auch Phosphite, Phosphine sowie Hypophosphite sind anstelle der im US-Patent angegebenen Natriumborhydride einsetzbar. Die zur Anwendung kommenden Polyacetylene können auch nach den Literaturstellen: "Transaction of Faraday Society" 64, (1968), Seiten 823 ff., "Journal of Chemical Society, Chemical Communications" 1977, Seiten 578 bis 580 oder "Berichte der Bunsengesellschaft, Physikalische Chemie" 68, (1964), Seiten 588 bis 567 erhalten worden sein. Die Polyacetylene sind in üblichen Lösungsmitteln unlöslich und fallen als schwarze, teilkristalline Materialien an. Sie weisen Molekulargewichte von 200 bis 100 000, bestimmt nach der Literaturstelle "Makromolekulare Chemie, Rapid Communications" 1, (1980) Seite 523, auf.

Nach erfindungsgemäßem Verfahren werden die Polyacetylene - vorzugsweise mit 0,1 bis 30, besonders bevorzugt mit 1 bis 5 Gew.-%, bezogen auf das Gewicht des Polyacetylens - Nitrilen in Gegenwart von rauchender Schwefelsäure

modifiziert. Die Polyacetylene reagieren mit den Nitrilen unter Bildung von Amidosulfonsäuren.

Diese Modifizierung erfolgt analog den Angaben des US-PS 3 506 707, wobei im Gegensatz zu den dort verwendeten Monoolefinen im erfindungsgemäßen Verfahren das Polyacetylen eingesetzt wird.

Als Nitrile können Mono-, Di-, Oligo- oder Polynitrile wie Acetonitril, Acrylnitril, Dicyan, Adipinsäuredinitril, Polyacrylnitril oder Oligoacrylnitril verwendet werden. Die bei der Modifizierung des Polyacetylens verwendete konzentrierte Schwefelsäure bzw. das Schwefeltrioxid wirkt gleichzeitig als Komplexierungsmittel bzw. als Dopant und ist für die Erhöhung der elektrischen Leitfähigkeit mitverantwortlich. Als Polyacetylen ist bevorzugt ein Produkt geeignet, das durch Pressen auf ein spezifisches Gewicht um ca. 1,0 $g/cm^3$ verdichtet ist.

Eine weitere Modifizierung des Polyacetylens besteht darin, in Gegenwart von Schwefelsäure Paraformaldehyd und Amine zur Reaktion zu bringen. Dieses Verfahren wird analog den Vorschriften, die für die Modifizierung von Styrol in der DE-OS 22 54 929 beschrieben sind, ausgeführt. Die so bevorzugt entsprechend der Formel (I) modifizierten Polyacetylene werden anschließend mit Alkalimetall, dessen Amid oder mit oxidierender Lewis-Säure umgesetzt.

Die erfindungsgemäß modifizierten Polyacetylene entsprechen bevorzugt der Formel (I) der oben angegebenen Zusammensetzung. Dabei ist $R^1$ ein stickstoffhaltiger organischer Rest der entweder eine mono-, di-, oligo- oder polyfunktionelle Carbonamidgruppe darstellt, z.B.

$CH_3-CO-NH$, $CH_2=CH-CONH-$, $(CH_2-\underset{CONH-}{CH})_n$ , wobei n=5 bis 100, $(CH_2-CH_2)_n-(CONH)_2$, wobei n=5 bis 100, oder ein Amin sein kann, z.B. $CH_2N(R^3)_2$, wobei $R^3$ eine Alkylgruppe mit vorzugsweise 1 bis 10 Kohlenstoffatomen darstellt. Wenn $R^1$ in der Formel (I) ein Carbonamid ist, ist $R^2$ H oder $SO_3H$, wenn $R^1$ ein Amin ist, ist $R^2$ vorzugsweise Wasserstoff.

Bevorzugte Zusatzstoffe zum modifizierten Polyacetylen sind unter den Alkalimetallen das Natrium oder Kalium und unter den Alkaliamiden das Natriumamid. Als Lewis-Säure wird bevorzugt ein Halogenderivat von Elementen der III., IV., V., VI., VII. oder VIII. Gruppe des Periodensystems der Elemente verwendet.

Nach besonders bevorzugter Verfahrensweise wird als Lewis-Säure die Verbindung $AsF_5$, $SbF_5$, $UF_6$, $SbCl_5$, $AlCl_3$, $BF_3$, $FeCl_3$, $CF_3SO_3H$, $VOCl_3$, $HClO_4$, $NO^+SbF_6^-$, $NO_2^+SbF_6^-$, $NO^+AsF_6^-$, $XeF_4$, $NO^+PF_6^-$, $I_2$, $Br_2$, $ICl$, $PF_5$, $CrO_2Cl_2$, $NO_2^+PF_6^-$, $NO^+BF_4^-$, $NO^+ClO_4^-$, $(CF_3)_2SO_4$, $NbF_5$, $WF_6$, $FeCl_3$, $CdCl_2$ oder $BF_3/CrOCl_2$ eingesetzt.

Als Lewis-Säure nach den erfindungsgemäßen Verfahren kommen ferner in Frage:

Aus der

<u>Gruppe VIII</u>

$KrF_2$, $XeOF_4$, $XeF_6$, $XeO_2F_2$, $HXeO_4$ sowie der

Gruppe VII

$ClF_3$, $ClF_5$, $BrF_3$, $IF_5$, $IF_7$, BrCl, BrI, $Cl_2O$, $Cl_2O_3$, $ClO_2$, $ClOClO_3$, $Cl_2O_6$, $Cl_2O_6$, $Cl_2O_7$, $Br_2O$, $BrO_2$, $Br_2O_5$, $Br_3O_2$, $BrO_3$, $I_4O_5$, $I_2O_5$, HClO, $HClO_2$, $HClO_3$, $HClO_4$, HOBr, $HBrO_2$, $HBrO_3$, $HBrO_4$, $HIO_3$, $HIO_4$, $FClO_3$, $ClF_3O$, $ClF_3O_2$, $FClO_2$, FClO, $BrO_2F$, $BrO_3F$, $IO_2F$, $IOF_3$, $IO_2F_3$, $IOF_5$ wie aus der

Gruppe VI

$FSO_3H$, $(FSO_3F)$, $R(SO_2F)_2$ mit R = NH, CH, FXe $(SO_3F)$, $FXe(OSeF_5)$, $FXe(OTeF_5)$, $Xe(OSeF_5)_4$, $Xe(OTeF_4)$, $FXe(OSeF_5)$, $F_{6-x}Cl(OSeF_5)_x$ mit x = 1 bis 5 FW $(OSeF_5)_x$ mit x = 1 bis 6,

sowie den

Nebengruppen

$AuF_5$, $PtF_6$, $IrF_6OsF_6$, $PtF_5$, $OsF_5$, $CrF_5$, $MoF_6$, $WF_5$, $MoF_5$, $VF_5$, $PuF_6$, $ReF_5$, $ReOF_5$, $CrO_2F_2$, $CrO_3$, $AuCl_3$, $PtCl_4$, $AuCl_3$.

Es kommen ferner in Frage:

Aus der

VI. Gruppe

$CF_3(CF_2)_nSO_3H$, $ClSO_3H$, $Cl_2CHSO_3H$, sowie der

V. Gruppe

$HPO_2F_2$, $F_2O_3F_4$, $PF_5$, $BiX_3$ mit X = F, Cl, Br oder i, und der

IV. Gruppe

$SiF_4$, $H_2SiF_6$, $GeX_4$, $SnX_4$, $PbX_4$ mit X = F, Cl, Br, der

III. Gruppe

$BX_3$, $AlX_3$, $GaX_3$, $TlX_3$ mit X = F, Cl, Br, I sowie der

Nebengruppen

$ReF_6$, $ReCl_5$, $ReCl_4$, $ReOF_4$, $VOF_3$, $NbOF_3$, $TaOF_3$, $VCl_3$, $VF_3$, $NbCl_5$, $TaCl_5$, $NbOCl_3$, $ThOCl_3$, $UCl_5$, $CuX_2$, AgX, AuX (X = Cl, Br)

$ZnX_2$, $CdX_2$, $HgX_2$ (X = Cl, Br, I)

NiX, $PdX_2$, $PtX_2$, (X = Cl, Br, I)

$CoX_2$, $RhX_2$, $IrX_2$ (X = Cl, Br, I)

$FeX_2$, $FeX_3$, $RuX_2$, $OsX_2$ (X = Cl, Br, I)

$MnX_2$, (X = Cl, Br, I)

$TiX_4$, $ZrX_4$ (X = F, Cl, Br, I)

$SeX_3$, $Y_3X$, $LaX_3$ Lanthanide $X_3$ (X = F, Cl, Br, I)

Actinide $X_3$, $X_5$ (X = F, Cl, Br)

Die Reaktion kann mit den gasförmigen Reaktanten oder mit Hilfssäuren wie: HF, $HOSeF_5$, $HOTeF_5$, $CF_3SO_3H$, $CF_3COOH$, $HClO_4$ oder Sulfosäuren, $CF_3PO_3H$, $(CF_3)_2$ POOH, $HPF_6$, $H_2SiF_6$, $H_2$, $SO_2Cl_2$, $SO_2F_2$, $SO_2ClF$, $CFCl_3$, HF, $CH_3CN$, $CH_3NO_2$ oder $C_2H_5NO_2$ durchgeführt werden. Die Komplexierung kann gegebenenfalls elektrochemisch entsprechend der EP-A2-36118 durchgeführt werden.

Die erfindungsgemäß hergestellten elektrisch leitfähigen polymeren Systeme mit elektrischen Leitfähigkeiten größer als $10^{-2}$ S/cm sind zur antistatischen Ausrüstung von Kunststoffen, zur Herstellung von Sonnenzellen, zur Umwandlung und Fixierung von Strahlung sowie zur Herstellung elektrischer und magnetischer Schalter und elektrische Speicher geeignet. Durch die Zusätze der starken Lewis-Säure entstehen sogenannte p-Leiter und durch die Alkalizusätze entstehen n-Leiter (vgl. "Journal of Chemical Education" 46, (1969), Nr. 2, Seite 82).

Beispiele 1 bis 10

In den folgenden Beispielen sind einige Varianten der Modifizierungsmittel und Komplexierungsmittel wiedergegeben und in der Tabelle werden die Eigenschaften der erfindungsgemäß hergestellten Polymeren aufgeführt. Die in den Beispielen genannten Zahlen sind Gewichtsteile. Sämtliche Versuche wurden unter reinem Stickstoff durchgeführt.

100 Teile Polyacetylen, hergestellt nach der Literaturstelle US-PS 3 092 613, werden bei 0°C mit 20 Teilen rauchender Schwefelsäure und 15 Teilen Acrylnitril versetzt und 3 Stunden bei einer Temperatur bis zu 15°C zur Reaktion gebracht.

Anschließend wird die Reaktionslösung in Wasser gefällt, mehrfach (bis zu 5 mal) gewaschen und getrocknet. Das so erhaltene Polymere wird anschließend mit n oder p-Dopants als Komplexierungsmittel versetzt.

Tabelle

| Beispiel Nr. | Modifizierungsmittel (Gew.-Teile) | Komplexierungsmittel (Gew. Teile) | elektrische Leitfähigkeit [S/cm] |
|---|---|---|---|
| 1 | 15 $CH_3CN$ | 50 $J_2$ | $3{,}6 \cdot 10^{-2}$ |
| 2 | 15 $(CN)_2$ | 30 $AsF_5$ | $3{,}6 \cdot 10^{-2}$ |
| 3 | 15 $C_2H_5CN$ | 30 $AsF_5$ | $4{,}1 \cdot 10^{-2}$ |
| 4 | 15 Adipodinitril | 26 $SbF_5$ | $2{,}9 \cdot 10^{-2}$ |
| 5 | 15 Polyacylnitril (Mol-Gew.ca.150000) | 10 Na | $5{,}3 \cdot 10^{-1}$ |
| 6 | 20 " " " | 20 Na | $6{,}8 \cdot 10^{-1}$ |
| 7 | 10 $CH_3CN$ | 25 Na | $5{,}0 \cdot 10^{-1}$ |
| 8 | 10 $CH_2$=CH-CN | 25 K | $4{,}5 \cdot 10^{+1}$ |
| 9 | 10 $CH_2$=CH-CN | 25 Na | $1{,}9 \cdot 10^{-1}$ |
| 10 | 10 Phthalodinitril | 20 $AsF_5$ | $2{,}6 \cdot 10^{-2}$ |

Beispiele 11 bis 15

Wird wie in den Beispielen 10 und 11 der DE-OS 22 54 929 beschrieben gearbeitet und statt Styrol (α-Methylstyrol) zugegeben, so wird nach dem Neutralisieren mit Natriumhydroxid die Reaktionslösung mit Wasser gewaschen, das unlösliche modifizierte Polyacetylen abfiltriert, neutral gewaschen und getrocknet.

Zur Herstellung von p-Leitern wird mit Lewis-Säure gedopt. In den nachfolgenden Beispielen ist die verwendete Lewis-Säure (entspricht dem p-Komplexierungsmittel) variiert. Als Modifizierungsmittel dient, wie in der Originalliteratur, Dimethylamin.

| Beispiel Nr. | Komplexierungsmittel (Gew.-Teile) | elektr. Leitfähigkeit S/cm) |
|---|---|---|
| 11 | 15 $H_2SO_4$ | $4,2 \cdot 10^{-2}$ |
| 12 | 15 $HClO_4$ | $5,6 \cdot 10^{-2}$ |
| 13 | 15 $BF_3$ | $1,0 \cdot 10^{-2}$ |
| 14 | 25 $AsF_5$ | $4,8 \cdot 10^{-2}$ |
| 15 | 30 $AsF_5$ | $2,5 \cdot 10^{-1}$ |

## Patentansprüche

1. Verfahren zur Herstellung von stabilen elektrisch leitfähigen Polymeren mit elektrischen Leitfähigkeiten größer als $10^{-2}$ S/cm aus Polyacetylen, dadurch gekennzeichnet, daß das Polyacetylen mit einer stickstoffhaltigen organischen Verbindung modifiziert und anschließend mit 0,1 bis 70 Gew.-%, bezogen auf das Polyacetylen, eines Alkalimetalls, dessen Amids oder einer oxidierenden Lewis-Säure umgesetzt wird.

2. Verfahren nach Anspruch 1, dadurch gekennzeichnet, daß das Polyacetylen in Gegenwart von Schwefelsäure mit organischen Nitrilen oder mit einer Mischung aus Paraformaldehyd und einem organischen Amin modifiziert wird.

3. Verfahren nach Anspruch 1 und 2, dadurch gekennzeichnet, daß mit 0,1 bis 30 Gew.-%, bezogen auf das Polyacetylen, stickstoffhaltiger organischer Verbindung modifiziert wird.

4. Verfahren nach Ansprüchen 1 bis 3, dadurch gekennzeichnet, daß man das Polyacetylen zu Polymeren mit Struktureinheiten der Formel (I):

$$\left[ -(CH)_x-(\underset{R^1\;\;R^2}{CH})_y- \right]_n \qquad I ,$$

modifiziert, wobei x, y und n Zahlen sind, x größer als y ist und x = 4 bis 990, y = 2 bis 10 und n = 6 bis 1000, $R^1$ = eine mono-, di-, oligo- oder polyfunktionelle Carbonamidgruppe oder ein Aminrest und $R^2$=H oder $SO_3H$ bedeuten, und anschließend mit Alkalimetall, dessen Amid oder oxidierender Lewis-Säure umsetzt.

5. Verfahren nach Ansprüchen 1 bis 4, <u>dadurch gekennzeichnet</u>, daß als oxidierende Lewis-Säure ein Halogenderivat von Elementen der III., IV., V., VI., VII. oder VIII. Gruppe des Periodensystems der Elemente eingesetzt wird.

6. Verfahren nach Ansprüchen 1 bis 4, <u>dadurch gekennzeichnet</u>, daß das modifizierte Polyacetylen mit einem Alkalimetall und/oder dessen Amid versetzt wird, wobei im Polymeren enthaltene Sulfogruppen in Salzform vorliegen.

7. Verwendung der nach Ansprüchen 1 bis 6 hergestellten elektrisch leitfähigen Polymeren in der Elektrotechnik zur Herstellung von Sonnenzellen, zur Umwandlung und Fixierung von Strahlung und zur Herstellung elektrischer und magnetischer Schalter und elektrischer Speicher.

8. Verwendung der nach Ansprüchen 1 bis 6 hergestellten elektrisch leitfähigen Polymeren zur antistatischen Ausrüstung von Kunststoffen.

Europäisches Patentamt

# EUROPÄISCHER RECHERCHENBERICHT

0070450
Nummer der Anmeldung

EP 82 10 6042

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| A | US-A-4 222 903 (ALAN J.HEEGER et al.) *Spalte 5, Zeilen 1-55* --- | 1 | C 08 F 8/42<br>H 01 B 1/12<br>H 01 L 29/28<br>H 01 L 31/02 |
| A | US-A-4 204 216 (ALAN J.HEEGER et al.) *Spalte 4, Zeile 35 - Spalte 7, Zeile 10* --- | 1 | |
| A | JOURNAL OF THE CHEMICAL SOCIETY, CHEMICAL COMMUNICATIONS, Nr. 15, 2. August 1979, Seiten 662-663, London (GB); SHEK-CHUNG GAU et al.: " 'Organic metals'. New classes of p-type dopants for converting polyacetylene, (CH)x into the 'metallic' state". *Insgesamt* ----- | 1 | RECHERCHIERTE SACHGEBIETE (Int. Cl. 3)<br>C 08 F<br>H 01 B<br>H 01 L |

Der vorliegende Recherchenbericht wurde für alle Patentansprüche erstellt.

| Recherchenort | Abschlußdatum der Recherche | Prüfer |
|---|---|---|
| DEN HAAG | 20-10-1982 | SCHRIJVERS H.J. |

KATEGORIE DER GENANNTEN DOKUMENTEN

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03.82